# EUROPÄISCHE PATENTSCHRIFT

(11) **EP 1 170 891 B1**
(45) Veröffentlichungstag und Bekanntmachung des Hinweises auf die Patenterteilung: **08.10.2003**
(21) Anmeldenummer: 00114278.5
(22) Anmeldetag: 04.07.2000
(51) Int. Cl.: H04H 7/00

(54) **Portables Behältnis zur Aufnahme eines ton- oder lichttechnischen Mischpultes**
Portable container for receiving a sound or light mixing console
Conteneur portable pour recevoir une console pour mélanger des signaux audiophoniques ou pour commander des installations lumineuses

(43) Veröffentlichungstag der Anmeldung: 09.01.2002
(73) Patentinhaber: Wilfer, Hans-Peter, 08258 Markneukirchen (DE)
(72) Erfinder: Wilfer, Hans-Peter, 08258 Markneukirchen (DE)
(74) Vertreter: Zech, Stefan Markus Dipl.-Phys.

(56) Entgegenhaltungen:
- GB-A- 2 344 810

## Beschreibung

Die Erfindung betrifft ein zur Aufnahme eines ton- oder lichttechnischen Mischpultes ausgebildetes, portables Behältnis, wobei das Behältnis einen Aufnahmerahmen für das Mischpult mit einem Boden, einer Vorderwand sowie einer Rückwand, zwei Seitenwänden und einer Oberseite aufweist und wobei das Behältnis derart ausgebildet ist, dass das Mischpult bei seinem Betrieb mit dem Aurhahmerahmen verbunden bleibt.

Bei größeren Veranstaltungen werden Mischpulte oft in einem 19-Zoll-Rack betrieben, das sich von einer Person nicht mehr transportieren lässt. Derartige Racks sind mit Rollen und zusätzlich oft mit Tragegriffen versehen, wobei die Racks nur von zwei Personen und auch nur über kurze Distanz transportiert werden können.

Weiterhin sind bereits Koffer und/oder Taschen bekannt, in denen ein Mischpult transportiert und/oder gelagert werden kann. Vor einer Veranstaltung muss das Mischpult allerdings aus dem Behältnis oder der Tasche entnommen auf einem Tisch oder einer anderen geeigneten Hilfsvorrichtung aufgebaut werden.

Derartige portable ton- oder lichttechnische Mischpulte werden oftmals in hektischer Atmosphäre an einen Veranstaltungsort transportiert, werden dort dem Behältnis entnommen und müssen dementsprechend nach der Veranstaltung abgebaut und wiederverpackt werden. Die herkömmlichen Behältnisse schützen das Mischpult während des Transportes vor Stößen, Verschmutzung und anderen äußeren Einwirkungen und dienen zur staubfreien und geschützten Aufbewahrung des Mischpultes.

Ein derartiges als Rack ausgebildetes Behältnis ist aus der GB 2 344 810 A bekannt. Bei diesem Behältnis bleibt das Mischpult mit einem Teil des Behältnisses bei seinem Betrieb verbunden.

Die Aufgabe der vorliegenden Erfindung besteht darin, ein verbessertes portables Behältnis für ein Mischpult zu schaffen, bei dem Auf- und Abbau des Mischpultes an einem Veranstaltungsort noch erleichtert wird.

Diese Erfindung wird gelöst mit einem an ein ton- oder lichttechnisches Mischpult angepassten Behältnis gemäß den Merkmalen des Patentanspruchs 1.

Vorteilhafte Weiterbildungen sind in den Unteransprüchen angegeben.

Ein Kerngedanke der vorliegenden Erfindung besteht darin, dass ein portables Behältnis für ein Mischpult geschaffen wird, das einen Aufnahmerahmen für das Mischpult umfasst, wobei das Behältnis, insbesondere der Aufhahmerahmen derart ausgebildet ist, dass das Mischpult bei seinem Betrieb mit dem Aufnahmerahmen verbunden bleiben kann und dass der Aufnahmerahmen weiterhin einen Einschubraum mit einer Einschuböffnung zur Aufnahme eines ton- oder lichttechnisches Effektgerätes definiert. Derartige Effektgeräte (Effekt-Prozessoren) werden - herkömmlicherweise meist im 19-Zoll-Maß - oftmals zusammen mit einem Mischpult betrieben. Bekannte tontechnische Effekttypen sind: reverb, delay, chorus, flanger, auto-pan, tap-delay, u.ä. Das Effektgerät wird vorzugsweise in einem Einschubraum unterhalb des Mischpultes ebenfalls am Aufnahmerahrnen befestigt, so daß, wenn sowohl Mischpult als auch Effektgerät im 19-Zoll-Maß gehalten sind, durch den Aufnahmerahmen ein transportables Mini-Rack definiert wird.

Ein weiterer, sich in synergetischer Weise einstellender Vorteil ist darin zu sehen, dass das Mischpult gerade in der hektischen Atmosphäre wie sie oft an einem Veranstaltungsort gegeben ist, zumindest teilweise gegen Stöße, Verunreinigungen sowie andere Einflüsse von außen geschützt bleibt.

Vorzugsweise sind im Behältnis, insbesondere im Aufhahmerahmen weiterhin eine oder mehrere Anschlussöffnungen vorgesehen, um das Mischpult und ggf. das Effektgerät anzuschließen.

Bevorzugtermassen umfasst der Aufhahmerahmen weiterhin eine Bedienöffnung für das Mischpult, die das Bedienen und/oder das Herausnehmen des Mischpultes aus dem Aufnahmerahmen gestatten.

In einer besonders bevorzugten Ausgestaltung ist am Aufnahmerahmen ein Ausschwenkmechanismus für das Mischpult angeordnet, der ein Verschwenken des Mischpultes vorzugsweise aus dem Aufhahmerahmen heraus gestattet. Durch das Verschwenken des Mischpultes wird das Anschließen von Leitungen unter Umständen noch erleichtert. Auch für den Betrieb lässt sich das Mischpult in eine für den Benutzer angenehme Winkelposition bringen.

Ergänzend oder alternativ zu der Bedien- und/oder Anschlussöffnung können weitere Funktionsöffnungen bzw. Funktionsbereiche vorgesehen sein, wie beispielsweise ein Bedienbereich, über die sich durch die Wand des Behältnisses hindurch zumindest einige Funktionen des Mischpultes steuern lassen. Beispielsweise können Tast- oder Hubschalter von außen durch eine transparente Folie hindurch betätigt werden. Eine weitere Funktionsöffnung könnte durch eine Lüftungsöffnung für das Mischpult definiert sein, so daß ein Lüfter zu Kühlzwecken Umgebungsluft einsaugen bzw. Abwärme an die Umgebung ausstoßen kann. Die Lüfteröffnung für die Zuluft könnte auch mit einem in die Wandlung des Behältnisses aufgenommenen Staubfilter ausgestattet sein. Schließlich kann ein infrarotdurchlässiges Funktionsfeld vorgesehen sein, das das Betreiben einer im Mischpult angeordneten Infrarotschnittstelle bei im Behältnis gelassenen Mischpult gestattet.

In einer vorteilhaften Weiterbildung sind die Bedien- und/oder Anschlußöffnungen insbesondere mittels Klappen verschließbar. Das Verschließen aller Bedienund/oder Anschlußöffhungen für den Transport bzw. die Lagerung des Mischpultes ist empfehlenswert, um das Mischpult vor Staub- oder Beschädigungen geschützt zu halten. Auch während des Betriebs können nicht benötigte Bedienund/oder Anschlußöffnungen ganz oder teilweise abgedeckt werden.

In einer weiter vorteilhaften Ausgestaltung umfassen die Abdeckeinrichtungen eine Deckklappe und/oder eine Rückklappe und/oder Frontklappe. Die Klappen sind über ein Scharnier fest mit dem Aufhahmerahmen des Behältnisses verbunden. In einer speziellen Ausgestaltung können die Klappen einstückig am Aufnahmerahmen angebracht sein, wobei das Scharnier dann durch einen flexiblen Materialbereich des Aufhahmerahmens gebildet sein kann. Alternativ ist ein Scharnier mit gegeneinander drehbaren mechanischen Komponenten gebildet, wobei dann Deckklappe, Rückklappe und Frontklappe aus anderen Materialien gebildet sein können.

In einer besonders bevorzugten Ausgestaltung ist das Behältnis mit einem Aufnahmerahmen, aus einem starren oder steifen Material wie beispielsweise Holz, Kunststoff gebildet. Dabei ist das Mischpult in diesem Aufnahmerahmen komplett aufgenommen, derart, daß das Mischpult aus dem Aufnahmerahmen nicht oder nicht wesentlich herausragt. Bei einer starren oder steifen Ausgestaltung des Aufnahmerahmens ist das Mischpult besonders sicher vor Beschädigungen beim Transport oder bei der Lagerung und - gemäß der Erfindung - auch im Betrieb geschützt.

In einer weiterhin bevorzugten Ausgestaltung ist das Behältnis bzw. der Aufilahmerahmen ergänzend oder alternativ zumindest teilweise aus einem flexiblen textilartigen oder textilähnlichen Material gebildet. In dieser Ausgestaltung kann das Behältnis leichter und möglicherweise kostengünstiger ausgebildet werden. Gleichzeitig lassen sich Kühlprobleme wesentlich einfacher lösen bzw. spielen überhaupt keine Rolle. Um das Mischpult dennoch gut transportieren und handhaben zu können, und gleichzeitig das Risiko von Beschädigungen zu reduzieren, kann das Behältnis mit Verstärkungselementen und ergänzend oder auch alternativ mit flexiblen ggf. stoßdämpfenden Protektoren versehen sein. Die Verstärkungselemente können beispielsweise plattenförmig aus Kunststoff oder Holz, insbesondere Sperrholz ausgebildet sein und versteifen das Behältnis ohne nennenswerte Erhöhung der Herstellungskosten und des Gewichts des gesamten Behältnisses.

In einer bevorzugten Ausgestaltung sind die Verstärkungselemente zwischen zwei Lagen des textilartigen oder textilähnlichen Materials eingeschlossen, vorzugsweise eingenäht. In dieser Ausgestaltung sind damit die Verstärkungselemente weder von außen noch von innen sichtbar. Ecken und Kanten der Verstärkungselemente werden durch das textilartige oder textilähnliche Material abgedeckt.

Um das Mischpult noch sicherer im Aufhahmerahmen des Behältnisses zu fixieren, sind Befestigungsschienen vorzugsweise innen an den Schmalseiten des Behältnisses vorgesehen, an die das Mischpult mit lösbaren Befestigungsmitteln fixiert werden kann. Die Befestigungsschienen selbst sind zweckmäßigerweise an einem jeweils an den Seitenwänden eingeschlossenen plattenförmigen Verstärkungselement angepaßt, wobei sich das plattenförmige Verstärkungselement zweckmäßigerweise im wesentlichen über den gesamten Querschnitt erstreckt. Die dauerhafte Verbindung, beispielsweise Verschraubung von Mischpult und Behältnis ist zweckmäßig, da die die gesamte Anordnung aus Behältnis und Mischpult weiter stabilisiert und nach einem Aspekt der vorliegenden Erfindung das Mischpult bei seinem Betrieb im Behältnis verbleibt. Wenn sich die vorliegende Erfindung auf ein an ein ton- oder lichttechnisches Mischpult angepaßtes Behältnis bezieht, so ist dies stets so zu verstehen, daß beispielsweise frontseitig immer noch Raum für die Aufnahme eines Effektgerätes vorgesehen sein kann.

In einer weiter bevorzugten Ausgestaltung sind die Deckklappe, vorzugsweise auch die Rückklappe, sowie die Frontklappe um eine zu der Seitenwand des Behältnisses im wesentlichen orthogonal verlaufende Achse verschwenkbar. Die Deckklappe wird dabei vorzugsweise nach hinten verschwenkt und kann dabei gleichzeitig als Abdeckung der Abschlußkabel dienen.

In einer anderen alternativen Ausgestaltung, vorzugsweise in der Version eines starren oder steifen Aufhahmerahmens können die Abdeckeinrichtungen vom Aufnahmerahmen des Behältnisses lösbar ausgestaltet sein, so daß am Veranstaltungsort bei Aufbau und Anschluß des Mischpultes dieses im Aufhahmerahmen des Behältnisses verbleibt und lediglich die Abdeckeinrichtungen für die Inbetriebnahme des Mischpultes entfernt werden.

Die Erfindung wird nachstehend auch hinsichtlich weiterer Merkmale und Vorteile anhand der Beschreibung von Ausführungsbeispielen und unter Bezugnahme auf die beiliegenden Zeichnungen näher erläutert.

Hierbei zeigen:
- Fig. 1: eine erste Ausführungsform eines erfindungsgemäßen Behältnisses in perspektivischer Ansicht.
- Fig. 2: die Ausführungsform des Behältnisses nach Fig. 1 in einer anderen perspektivischen Ansicht.
- Fig. 3: eine Schnittansicht des Behältnisses nach Fig. 1.
- Fig. 4: eine alternative Ausführungsform des Behältnisses nach der Erfindung in Explosionsansicht.
- Fig. 5: eine Schnittansicht durch die Ausführungsform nach Fig. 4.
- Fig. 6a: das in Fig. 4 dargestellte Behältnis in geschlossener Form in einer ersten perspektivischen Ansicht.
- Fig. 6b: das in Fig. 4 dargestellte Behältnis in geschlossener Form in einer zweiten perspektivischen Ansicht.
- Fig. 7: eine dritte alternative Ausführungsform des Behältnisses in perspektivischer Ansicht.
- Fig. 8: die Ausführungsform des Behältnisses nach Fig. 7 in einer anderen perspektivischen Ansicht.
- Fig. 9: eine Schnittansicht des Behältnisses nach Fig. 7.

In Fig. list in einer ersten Ausführungsform des Behältnisses nach der Erfindung in perspektivischer Ansicht veranschaulicht. Das Behältnis 13 umfaßt einen Aufnahmerahmen 26 für das Mischpult mit einem Boden 12, einer Vorderwand 16, einer Rückwand 17, zwei Seitenwänden 14, 15 und einer oben offenen Oberseite 11. Das Mischpult ist zumindest beim Transport oder der Lagerung durch den Aufhahmerahmen 26 im wesentlichen eingeschlossen. Im Betrieb bleibt das Mischpult zumindest mit dem Aufhahmerahmen verbunden. In der hier dargestellten Ausführungsform umfaßt der Aufhahmerahmen 26 eine aus einem widerstandsfähigen textilartigen oder textilähnlichen Material gebildete Hülle 51. Die Vorderwand 16 weist eine sich annähernd über die gesamte Breite erstreckende Einschuböffnung 43 auf, die Rückwand 17 eine rechteckförmige langgestreckte Anschlußöffnung 22. Durch die offene Oberseite 11 wird eine Bedienöffnung 21 definiert, um ein in den Aufnahmerahmen eingesetztes Mischpult von oben bedienen zu können. An dem aus textilartigen oder textilähnlichem Material gebildeten Aufnahmerahmen 26 sind Abdeckeinrichtungen, nämlich eine Deckklappe 23, eine Rückklappe 24 sowie eine Frontklappe 25 angeordnet. In der vorliegenden Ausführungsform sind Deckklappe 23, Rückklappe 24 und Frontklappe 25 aus dem gleichen Material wie der Aufnahmerahmen 26 gebildet. Der Aufnahmerahmen umfaßt eine ohne mehrere Lagen des textilartigen oder textilähnlichen Materials, wobei die Deckklappe 23, Rückklappe 24 und Frontklappe 25 vorzugsweise nahtlos mit der jeweiligen Lage des Aufhahmerahmens 25 zusammenhängen.

Um den Aufnahmerahmen 26 und die Deckklappe, evtl. die Rückklappe und die Frontklappe zu versteifen, sind zwischen den Lagen 27, 28 des textilartigen oder textilähnlichen Materials plattenförmige Verstärkungselemente 18, 19, 20, 29 eingearbeitet, die sich jeweils im wesentlichen über die gesamte Fläche der Deckklappe 23, des Bodens 12 sowie der Seitenwände 14, 15 erstrecken.

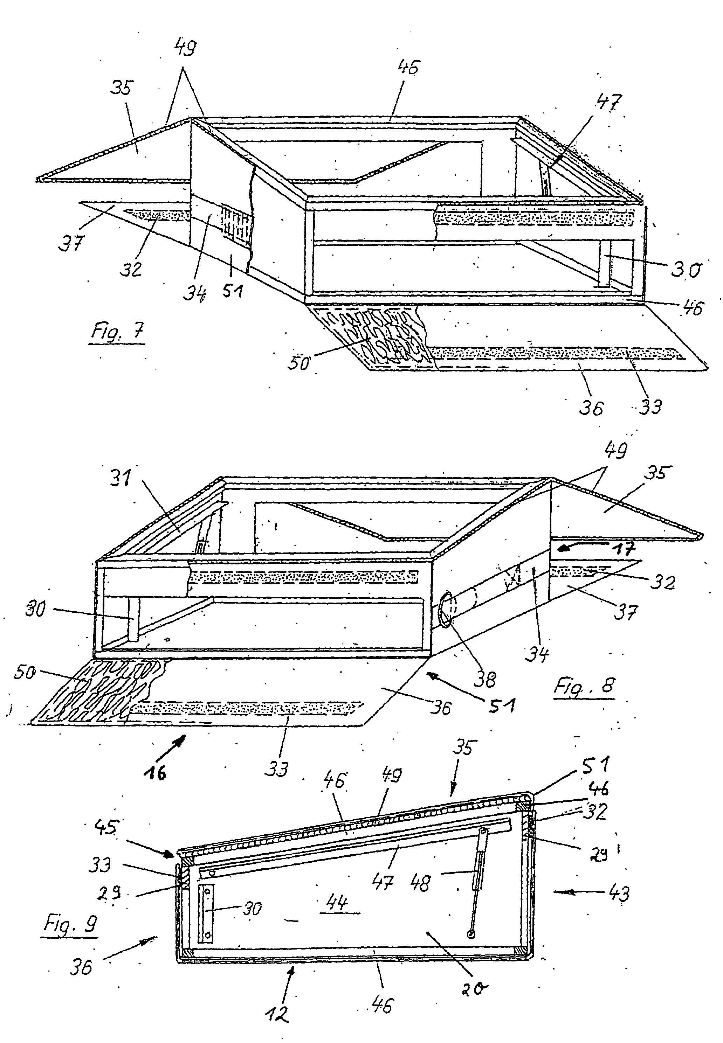

Ein in den Aufhahmerahmen 26 eingesetztes Mischpult kann bei geöffneter Deckklappe 23 bei seinem Betrieb im Behältnis verbleiben. Die erforderlichen Anschlüsse können über die Anschlußöffnung 22 im Aufhahmerahmen 26 kontaktiert werden, wobei das an das Mischpult herangeführte Kabel zusätzlich durch die nach hinten weggeklappte Deckklappe 23 überdeckt und geschützt wird. Darüber hinaus ist im Aufnahmerahmen 26 noch Raum zur Aufnahme von vorne her eingeschobenen Effektgeräten vorgesehen, die dann bei geöffneter Frontklappe 25 über die Einschuböffnung 43 in der Vorderwand 16 bedient werden können. Die Frontklappe 25 und die Rückklappe 24 können über Klettverschlüsse 32, 33 in Schließposition gehalten werden. Die Deckklappe 23 wird ebenfalls über die Klettlösung oder einer anderen Verschließeinrichtung, wie beispielsweise eine Riemen-Schnallenlösung, oder einen Reißverschluß (vgl. Fig. 7, 8, oder 9) in Schließposition gehalten.

Außen auf den Seitenwänden 14, 15 sind Bänder 34 angeordnet, vorzugsweise aufgenäht, die Ösen 38, 39 zum Einhängen eines Tragegurtes umfassen.

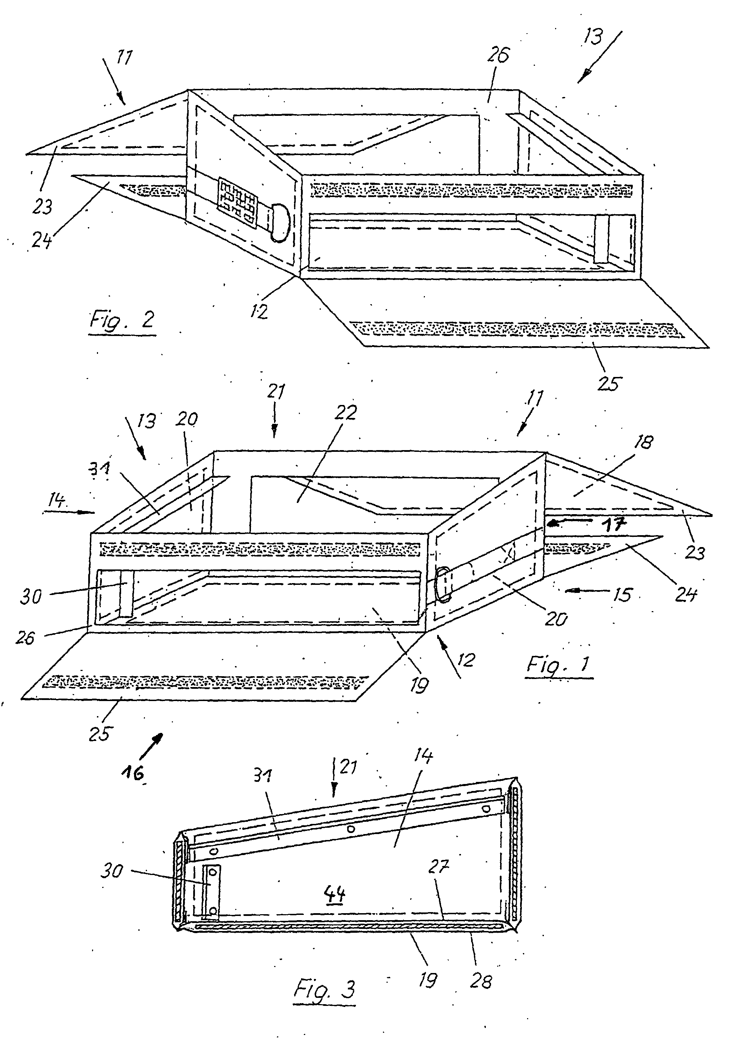

Auf der Innenseite der Seitenwände 14, 15 sind, wie in der Schnittansicht nach Fig. 3 noch besser erkennbar, Befestigungsschienen 30, 31 befestigt, vorzugsweise mit dem jeweiligen eingeschlossenen plattenförmigen Verstärkungselement 20 vernietet oder verschraubt. Die kurze, im wesentlichen vertikal zur Fläche des Bodens 12 ausgerichtete Befestigungsschiene 30 dient der frontseitigen Befestigung eines Effektgerätes. Eine leicht gegenüber der Fläche des Bodens 12 geneigte Befestigungsschiene 31 verläuft im wesentlichen über die gesamte Breite der Seitenwand 14. Sie dient der Fixierung des Mischpultes im Behältnis 13. Das Mischpult kann an der Befestigungsschiene 31 vorzugsweise festgeschraubt, festgeschnappt oder auf andere Weise befestigt werden. Beide Befestigungsschienen 30, 31 des Mischpultes und des Effektgerätes sind hier derart ausgebildet und beabstandet, daß sie auf das meist übliche 19-Zoll Maß der Geräte abgestimmt sind.

Die Seitenwand umfaßt bei der Ausführungsform nach den Fig. 1 bis 3 von außen nach innen betrachtet eine Lage 27 aus textilartigen oder textilähnlichen Material, die an einer Seite des plattenförmigen Verstärkungselementes 20 anliegt. Auch auf der gegenüberliegenden Seite des plattenförmigen Verstärkungselementes 20 ist eine gleiche oder ähnliche Lage von textilartigen oder textilähnlichem Material angeordnet, wobei beide Lagen um das Verstärkungselement herum miteinander verbunden sind, so daß das Verstärkungselement eingeschlossen ist. An der Innenseite der so definierten Seitenwand 14 ist schließlich die Befestigungsschiene 31 angebracht, wobei diese durch eine Nietverbindung mit dem plattenförmigen Verstärkungselement 20 verbunden ist.

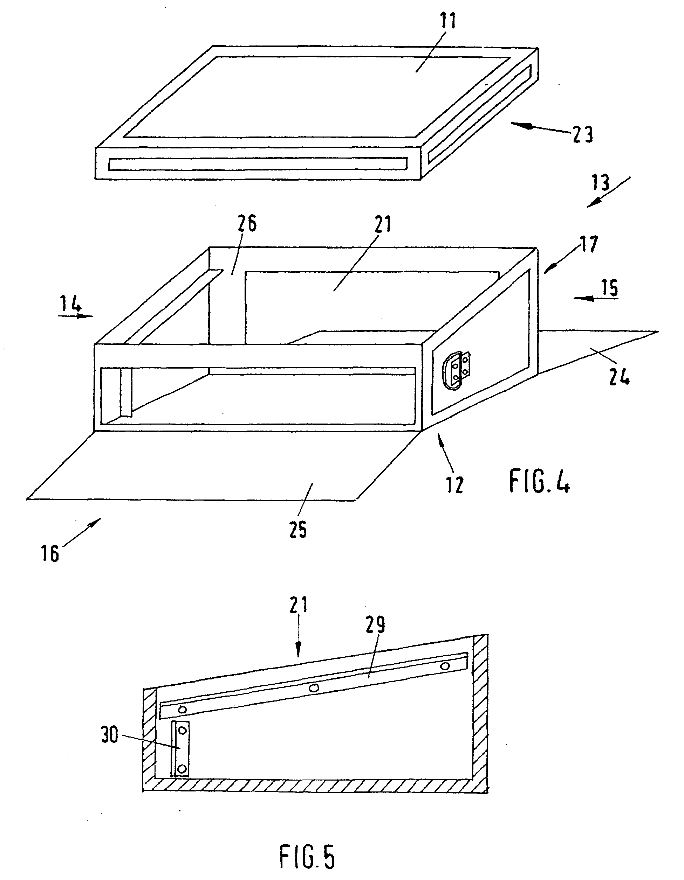

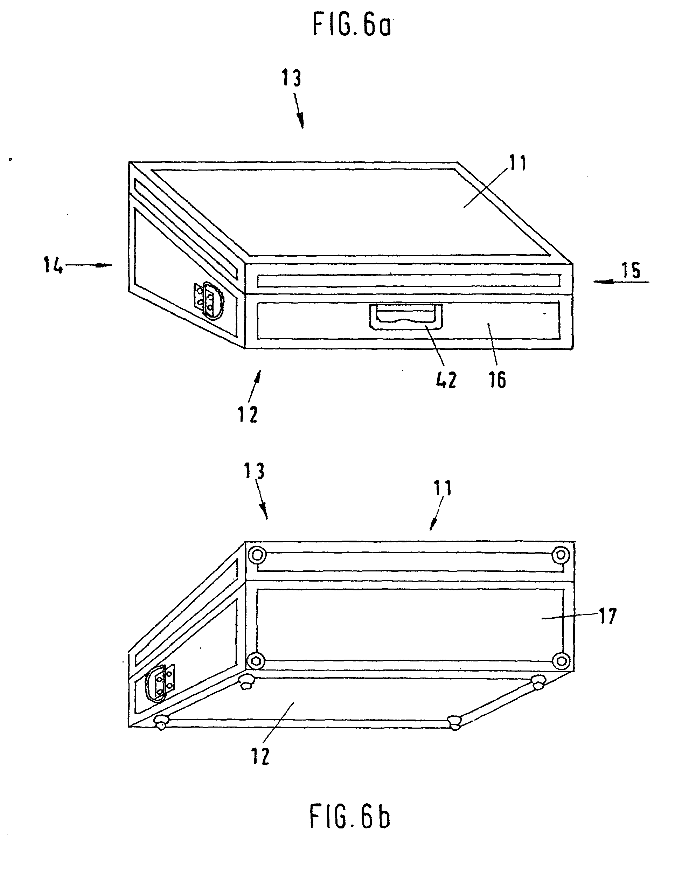

In Fig. 4 ist eine alternative Ausführungsform für ein Behältnis zur Aufnahme eines Mischpultes dargestellt. Das Behältnis nach den Fig. 4, 5, 6a und 6b umfaßt einen Aufhahmerahmen 26 aus einem starren oder steifen Material wie Holz, Kunststoff oder Metall. Der Aufnahmerahmen 26 umfaßt auch hier einen Boden 12, zwei Seitenwände 14, 15, eine Vorderwand 16 sowie eine Rückwand 17. An der dem Boden 12 gegenüberliegenden Oberseite 11 des Aufnahmerahmens 26 wird eine Bedienöffnung 21 definiert, die mit einem Deckel 35 verschließbar ist. In der Vorderwand 16 ist wiederum eine Einschuböffnung zur Bedienung evtl. zusätzlich in den Aufnahmerahmen 26 einschiebbarer Effektgeräte vorgesehen. In der Rückwand 17 ist eine langgestreckte Anschlußöffnung 22 ausgebildet, so daß Anschlüsse des Mischpultes und ggf. des Effektgerätes von außen zugänglich sind und sich die Gesamtanordnung aus Mischpult, Effektgerät und Behältnis 13 leicht verkabeln läßt. Zum Transport bzw. zur Lagerung können die Bedienöffnung 21 mit dem Deckel 35, die Anschlußöffnung 22 mit der Rückabdeckung 37 und die Einschuböffnung mit der Frontabdeckung 36 verschlossen werden, so daß das Mischpult allseits eingeschlossen und vor Beschädigungen und Staub geschützt ist (vgl. Fig. 6a, Fig. 6b).

Deckel 35, Frontabdeckung 36 und Rückabdeckung 37 können in unterschiedlicher an sich bekannter Weise am Aufnahmerahmen 26 lösbar befestigt werden. In einer speziellen Ausgestaltung (nicht gezeigt) sind Deckel 35, Frontabdeckung 36 und Rückabdeckung 37 ähnlich wie in der Ausführungsform in den Figuren 1 bis 3 als Klappen ausgebildet, wobei spezielle Scharniere auch ein komplettes Abnehmen von Deckel, Frontabdeckung und Rückabdeckung zulassen. Die Verriegelung erfolgt dann über Kofferschnallen, Riegel, Verrastungen oder in anderer herkömmlicher Weise.

In Fig. 5 ist eine Schnittansicht durch den Aufnahmerahmen 26 des Behältnisses 13 nach Fig. 4 dargestellt, wobei Befestigungsschienen 30, 31 - ähnlich wie in Fig. 3 - an der Seitenwand 14 befestigt sind. Die Befestigungsschienen 30, 31 dienen zur Fixierung eines von der Vorderwand her bedienbaren Effektgerätes sowie zur Fixierung des Mischpultes im Behältnis 13.

In den Fig. 6a und 6b ist das Behältnis in verschlossener Form dargestellt. Ösen 38, 39 sind mit entsprechenden Befestigungsplatten 40, 41 jeweils außen an der Seitenwand 14, 15 des Behältnisses 13 befestigt. Die Ösen 38, 39 dienen zum Einhängen eines (nicht dargestellten) Tragegurtes. Alternativ läßt sich das Behältnis auch über einen Tragegriff 42 transportieren.

Die Frontklappe 25 sowie Rückklappe 24 lassen sich mit weiteren Klettverschlüssen auf der Unterseite des Bodens 12 des Behältnisses 13 fixieren.

In Fig. 7 ist eine dritte alternative Ausführungsform für ein Behältnis zur Aufnahme eines Mischpultes sowie eines Effektgerätes dargestellt. In der hier dargestellten Ausführungsform umfaßt der Aufhahmerahmen 26 eine aus einem widerstandsfähigen textilartigen oder textilähnlichem Material, wie beispielsweise Nylongewebe in gebildete Hülle 51, einen Verstärkungsrahmen 45, der aus Metall- oder Kunststoffprofilen 46 gebildet ist sowie zwischen dem Verstärkungsrahmen 45 angeordnete Verstärkungselemente 18, 19, 20, 29, die hier als Sperrholzplatten zwischen dem aus Metall- oder Kunststoffprofilen 46 gebildeten Verstärkungsrahmen 45 eingesetzt sind. Die Grundkonzeption vom Boden 12, Seitenwänden 14, 15, Vorderwand 16, Rückwand 17 sowie dem Bedienöffnungen 21 und 32 entspricht der bereits anhand der Ausführungsform nach den Fig. 1 bis 3 erläuterten Gestaltung. Zum Verschließen der Bedienöffhung 21 für das Mischpult ist die Deckelklappe 23 randseitig mit einer Hälfte eines Reißverschlusses 49 versehen, dessen andere Hälfte korrespondierend entlang des oberen Randes des Aufhahmerahmens 26 an der Hülle 51 des Behältnisses angeordnet ist.

Um das Mischpult in eine gewünschte Position zu bringen, wirkt ein ausschwenkmechanismus 47 mit den Befestigungsschienen 31 an den Seitenwänden 14, 15 zusammen, so daß das Mischpult aus der Bedienöffnung 21 heraus nach vorne oben verschwenkt werden kann. Um den Verschwenkmechanismus 47 in einer gewünschten Position zu arretieren, sind Rastprofile 48 vorgesehen, welche die Befestigungsschiene 31 in einer gewünschten Winkelposition relativ zum Boden 12 arretiert.

Die Hülle 51 ist einer innenliegenden Polsterung 50 versehen zur Stoßdämmung oder Stoßdämpfung.

### Bezugszeichenliste

- 11: Oberseite
- 12: Unterseite, Boden
- 13: Behältnis
- 14, 15: Seitenwand
- 16 6: Vorderwand
- 17: Rückwand
- 18,19,20,29, 29': Verstärkungselemente
- 21: Bedienöffnung (Mischpult)
- 22: Anschlußöffnung
- 23: Abdeckeinrichtung, Deckklappe
- 24: Abdeckeinrichtung, Rückklappe
- 25: Abdeckeinrichtung, Frontklappe
- 26: Aufnahmerahmen
- 27, 28: Lagen (des textilartigen oder textilähnlichen Materials)
- 30, 31: Befestigungsschienen
- 32, 33: Klettverschlüsse
- 34: Bänder
- 35: Deckel
- 36: Frontabdeckung
- 37: Rückabdeckung
- 38, 39: Ösen
- 40, 41: Befestigungsmittel
- 42: Tragegriff
- 43: Einschuböffnung
- 44: Einschubraum
- 45: Verstärkungsrahmen
- 46: Metall- oder Kunststoffprofil
- 47: Ausschwenkmechanismus
- 48: Rastprofile
- 49: Reißverschluß
- 50: Polsterung
- 51: Hülle

## Patentansprüche

1. Zur Aufnahme eines ton- und/oder lichttechnischen Mischpultes ausgebildetes, portables Behältnis, wobei das Behältnis (13) einen Aufnahmerahmen (26) für das Mischpult mit einem Boden (12), einer Vorderwand (16) sowie einer Rückwand (17), zwei Seitenwänden (14, 15) und eine Oberseite (11) aufweist, wobei das Behältnis derart ausgebildet ist, dass das Mischpult bei seinem Betrieb mit dem Aufnahmerahmen (26) verbunden bleibt, **dadurch gekennzeichnet, dass** der Aufnahmerahmen (26) weiterhin einen Einschubraum (44), mit einer Einschuböffnung zur Aufnahme eines tonund/oder lichttechnischen Effektgerätes definiert.

2. Behältnis nach Anspruch 1,
**dadurch gekennzeichnet,**
**dass** der Aufnahmerahmen (26) weiterhin eine oder mehrere Anschlussöffnungen (22) zur Kontaktierung des Mischpultes und ggf. des Effektgerätes umfasst.

3. Behältnis nach einem der vorhergehenden Ansprüche,
**dadurch gekennzeichnet,**
**dass** der Aufnahmerahmen (26) vorzugsweise an seiner Oberseite (11) eine Bedienöffnung (21) umfässt, welche die Bedienung des Mischpultes im Aufnahmerahmen (26) und/oder die Herausnahme des Mischpultes aus dem Aufnahmerahmen (26) gestattet.

4. Behältnis nach Anspruch 3,
**dadurch gekennzeichnet,**
**dass** am Aufnahmerahmen (26) ein Ausschwenkmechanismus (47) angeordnet ist, der ein Verschwenken des Mischpultes vorzugsweise aus der Bedienöffnung (21) heraus gestattet.

5. Behältnis nach einem der Ansprüche 1 bis 4,
**dadurch gekennzeichnet,**
**dass** die Einschuböffnung die Bedien- (21) und/oder Anschlussöffnungen (22) mit Abdeckeinrichtungen (23, 24, 25) verschließbar sind.

6. Behältnis in Anspruch 5,
**dadurch gekennzeichnet,**
**dass** die Abdeckeinrichtungen eine Deckklappe (23) und/oder eine Rückklappe (24) und/oder eine Frontklappe (25) umfassen.

7. Behältnis nach einem der vorhergehenden Ansprüche,
**dadurch gekennzeichnet,**
**dass** der Aufnahmerahmen (26) einen aus Metall- oder Kunststoffprofilen (46) gebildeten Verstärkungsrahmen (45) umfaßt, der vorzugsweise die außenliegenden Kanten des Aufnahmerahmens (26) begrenzt.

8. Behältnis nach einem der vorhergehenden Ansprüche,
**dadurch gekennzeichnet, .**
**dass** das Behältnis (13) zumindest teilweise aus einem flexiblen textilartigen oder textilähnlichen Material gebildet ist.

9. Behältnis einem der vorhergehenden Ansprüche,
**dadurch gekennzeichnet,**
**dass** das Behältnis (13) bereichsweise mit steifen Verstärkungselementen (18, 19, 20) versehen ist.

10. Behältnis nach Anspruch 9,
**dadurch gekennzeichnet,**
**dass** die Verstärkungselemente (18, 19, 20) zwischen zwei Lagen (27, 28) des textilartigen oder textilähnlichen Materials eingeschlossen sind.

11. Behältnis einem der Ansprüche 1 bis 10,
**dadurch gekennzeichnet,**
**dass** innerhalb des Behältnisses (13) Einrichtungen zur lösbaren Befestigung, insbesondere Befestigungsschienen (30, 31) vorzugsweise innen an den Seitenwänden (14, 15) vorgesehen sind, um das Mischpult und ggf. ergänzende Effektgeräte am Behältnis (13) zu fixieren.

12. Behältnis einem der Ansprüche 6 bis 11,
**dadurch gekennzeichnet,**
**dass** die Deckklappe (23), vorzugsweise auch die Rückklappe (24) sowie die Frontklappe (25) um eine zu den Seitenwände (24, 15) des Behältnisses (13) im Wesentlichen orthogonal verlaufende Achse verschwenkbar sind.

13. Behältnis einem der vorhergehenden Ansprüche,
**dadurch gekennzeichnet,**
**dass** die Abdeckeinrichtungen (23, 24, 25) vom Aufhahmerahmens (26) des Behältnisses (13) lösbar sind.

## Claims

1. A portable container designed to receive a sound and/or light mixing console, wherein the container (13) comprises a receiving frame (26) for the mixing console with a base (12), a front wall (16) and a rear wall (17), two lateral walls (14, 15) and a top (11), wherein the container is designed in such a way that the mixing console remains connected to the receiving frame (26) during its operation, **characterized in that** the receiving frame (26) additionally defines a slide-in space (44) with a slide-in opening for receiving a sound and/or light effecter.

2. A container according to Claim 1, **characterized in that** the receiving frame (26) additionally comprises one or more connexion openings (22) for contacting the mixing console and optionally the effecter.

3. A container according to one of the preceding Claims, **characterized in that** the receiving frame (26) comprises, preferably at its top, an access opening (21) which allows the operation of the mixing console in the receiving frame (26) and/or the removal of the mixing console from the receiving frame (26).

4. A container according to Claim 3, **characterized in that** a swing-out mechanism (47), which allows the mixing console to be pivoted preferably out of the access opening (21), is arranged on the receiving frame (26).

5. A container according to one of Claims 1 to 4, **characterized in that** the slide-in opening, the access opening (21) and/or connexion openings (22) are closable by covering devices (23, 24, 25).

6. A container in Claim 5, **characterized in that** the covering devices comprise a covering flap (23), and/or a rear flap (24) and/or a front flap (25).

7. A container according to one of the preceding Claims, **characterized in that** the receiving frame (26) comprises a reinforcement frame (45) which is formed from metallic or plastics-material sections (46) and which preferably bounds the edges of the receiving frame (26) situated on the outside.

8. A container according to one of the preceding Claims, **characterized in that** the container (13) is formed at least in part from a flexible textile-like material or material similar to a textile.

9. A container according to one of the preceding Claims, **characterized in that** the container (13) is provided locally with rigid reinforcement elements (18, 19, 20).

10. A container according to Claim 9, **characterized in that** the reinforcement elements (18, 19, 20) are enclosed between two layers (27, 28) of the textile-like material or material similar to a textile.

11. A container [according to] one of Claims 1 to 10, **characterized in that** devices for releasable fastening, in particular fastening rails (30, 31), are provided inside the container (13), preferably on the inside of the lateral walls (14, 15), in order to fix the mixing console and optionally additional effecters on the container (13).

12. A container [according to] one of Claims 6 to 11, **characterized in that** the covering flap (23), and preferably also the rear flap (24) as well as the front flap (25) are pivotable about an axis extending substantially at a right angle to the lateral walls (14, 15) of the container (13).

13. A container [according to] one of the preceding Claims, **characterized in that** the covering devices (23, 24, 25) are releasable from the receiving frame (26) of the container (13).

## Revendications

1. Conteneur portable pour le logement d'une console de mixage de son et/ou de lumière, le conteneur (13) présentant un cadre de logement (26) pour la console de mixage avec un fond (12), une paroi avant (16) et une paroi arrière (17), deux parois latérales (14, 15) et un côté supérieur (11), le conteneur étant conçu de telle sorte que la console de mixage reste reliée au cadre de logement (26) lors de son fonctionnement, **caractérisé en ce que** le cadre de logement (26) définit également un espace d'insertion (44), avec une ouverture d'insertion pour le logement d'un appareil à effet de son et/ou de lumière.

2. Conteneur selon la revendication 1,
**caractérisé en ce que**
le cadre de logement (26) comprend également une ou plusieurs ouvertures de branchement (22) pour le raccordement de la console de visualisation et éventuellement de l'appareil à effet.

3. Conteneur selon l'une quelconque des revendications précédentes,
**caractérisé en ce que**
le cadre de logement (26) comprend de préférence sur son côté supérieur (11) une ouverture de commande (21), qui permet la commande de la console de visualisation dans le cadre de logement (26) et/ou la sortie de la console de visualisation du cadre de logement (26).

4. Conteneur selon la revendication 3,
**caractérisé en ce que**
sur le cadre de logement (26) est disposé un mécanisme de basculement vers l'extérieur (47), qui permet un basculement de la console de mixage de préférence hors de l'ouverture de commande (21).

5. Conteneur selon l'une quelconque des revendications 1 à 4,
**caractérisé en ce que**
l'ouverture d'insertion, l'ouverture de commande (21) et/ou les ouvertures de branchement (22) peuvent être fermées avec des dispositifs de recouvrement (23, 24, 25).

6. Conteneur selon la revendication 5,
**caractérisé en ce que**
les dispositifs de recouvrement comprennent un volet de revêtement (23) et/ou un volet arrière (24) et/ou un volet avant (25).

7. Conteneur selon l'une quelconque des revendications précédentes,
**caractérisé en ce que**
le cadre de logement (26) comprend un cadre de renfort (45) formé à partir de profilés de métal ou de plastique (46), qui de préférence délimite les arêtes extérieures du cadre de logement (26).

8. Conteneur selon l'une quelconque des revendications précédentes,
**caractérisé en ce que**
le conteneur (13) est formé au moins partiellement dans un matériau flexible du type textile ou similaire au textile.

9. Conteneur selon l'une quelconque des revendications précédentes,
**caractérisé en ce que**
le conteneur (13) est pourvu dans certaines zones d'éléments de renfort (18, 19, 20) rigides.

10. Conteneur selon la revendication 9,
**caractérisé en ce que**
les éléments de renfort (18, 19, 20) sont enfermés entre deux couches (27, 28) du matériau du type textile ou semblable au textile.

11. Conteneur selon l'une quelconque des revendications 1 à 10,
**caractérisé en ce que**
il est prévu à l'intérieur du conteneur (13) des dispositifs pour la fixation amovible, en particulier des rails de fixation (30, 31) de préférence à l'intérieur sur les parois latérales (14, 15), afin de fixer la console de commande et éventuellement des appareils à effet complémentaires sur le conteneur (13).

12. Conteneur selon l'une quelconque des revendications 6 à 11,
**caractérisé en ce que**
le volet de revêtement (23), de préférence également le volet arrière (24) et le volet avant (25) peuvent basculer autour d'un axe disposé perpendiculairement aux parois latérales (24, 15) du conteneur (13).

13. Conteneur selon l'une quelconque des revendications précédentes,
**caractérisé en ce que**
les dispositifs de recouvrement (23, 24, 25) peuvent être détachés du cadre de logement (26) du conteneur (13).
